# FASCICULE DE BREVET EUROPEEN

(11) **EP 2 295 994 B1**
(45) Date de publication et mention de la délivrance du brevet: **09.05.2012**
(21) Numéro de dépôt: 10193704.3
(22) Date de dépôt: 22.01.2008
(51) Int. Cl.: G01R 19/165, B60L 3/00

(54) **Dispositif et procédé de mesure du courant consommé par une chaîne de traction d'un véhicule ferroviaire**
Vorrichtung und Verfahren zum Messen des von der Antriebseinheit eines Schienenfahrzeugs verbrauchten Stroms
Device and method for measuring the power consumed by a power train of a railway vehicle

(30) Priorité: 22.01.2007 FR 0752798
(43) Date de publication de la demande: 16.03.2011
(62) Demande divisionnaire de: 08100744.5
(73) Titulaire: Faiveley Transport, 92230 Gennevilliers (FR)
(72) Inventeur: Leclercq, Gérald, 37270 Montlouis Sur Loire (FR)
(74) Mandataire: Callon de Lamarck, Jean-Robert

(56) Documents cités:
- EP-A2- 0 297 728
- EP-A2- 0 596 566
- EP-A2- 0 743 528
- EP-A2- 1 564 064
- DE-A1-102004 042 101

## Description

Le domaine de l'invention est celui du captage de courant pour la chaîne de traction d'un matériel roulant ferroviaire, en particulier pour des locomotives, des autorails et des motrices ferroviaires.

L'invention concerne plus précisément un dispositif destiné pour mesurer l'énergie consommée par une telle chaîne de traction ferroviaire.

Elle trouve avantageusement application pour les matériels roulant ferroviaires à chaîne de traction multi-tension, c'est-à-dire les matériels de traction aptes à être alimentés par différentes valeurs de tension, et cela tant sous la forme d'une tension de courant continu que sous la forme d'une tension de courant alternatif.

Une chaîne de traction multi-tension peut ainsi être alimentée à partir de courants électriques captés sur une ligne caténaire à courant continu (dont la tension est par exemple de 1500 Volt ou de 3000 Volt) ou alternativement à partir de courants électriques captés sur une ligne caténaire à courant alternatif (dont la tension est par exemple de 15000 Volt à 16 2/3 Hertz ou encore de 25000 Volt à 50 Hertz).

La captation du courant sur la ligne caténaire est assurée par un appareil dit pantographe comprenant une structure articulée fixée sur le toit d'une rame ferroviaire. Une ligne de puissance est prévue pour acheminer le courant capté par le pantographe à destination d'un moteur électrique permettant d'entraîner la rame.

Dans une chaîne de traction ferroviaire classique, on trouve, outre le pantographe, un organe de mesure permettant de connaître le courant consommé et de déclencher des sécurités en cas de court-circuit dans la chaîne de traction.

Dans le cas d'une chaîne de traction multi-tension, cet organe de mesure de courant est composé de deux types de dispositifs de mesure de courant, pour fournir une information aussi bien dans le cas d'une alimentation en courant alternatif que dans le cas d'une alimentation en courant continu.

Un transformateur de courant disposé sur la ligne de puissance directement en aval du pantographe permet ainsi de fournir une mesure de courant dans le cas d'une alimentation en courant alternatif, tandis qu'un shunt situé près du bloc moteur ou une sonde à effet Hall permet de fournir une mesure de courant dans le cas d'une alimentation en courant continu.

Un tel organe de mesure de courant s'avère toutefois encombrant, relativement lourd et couteux.

Un premier objectif de l'invention est de proposer un organe de mesure du courant consommé par une chaîne de traction ferroviaire qui ne présente pas ces inconvénients de l'état de la technique.

On peut également trouver dans une chaîne de traction ferroviaire classique, un organe de mesure de la tension délivrée par la ligne caténaire.

Un premier type d'organe connu de mesure de tension présente un transformateur dont une extrémité de l'enroulement primaire est reliée au pantographe et dont l'autre extrémité est reliée à la masse par l'intermédiaire d'un pont résistif. Le transformateur permet de réaliser une mesure de la tension dans le cas d'une alimentation en courant alternatif, tandis que le pont résistif permet de réaliser une mesure de la tension dans le cas d'une alimentation en courant continu.

Outre des problèmes d'isolation, ce premier type d'organe de mesure de tension s'avère lourd et couteux.

Un second type d'organe connu de mesure de tension est présenté dans le document EP0743528. Cet organe est notamment formé d'un boîtier électronique de mesure POD qui comprend un diviseur de tension résistif dont la référence est à la masse, ainsi qu'un transformateur d'isolement alimenté depuis un boîtier électronique d'interface FOR. Le boîtier POD est monté en toiture du véhicule ferroviaire, tandis que le boîtier FOR est disposé à l'intérieur du véhicule, les deux boîtiers étant reliés par une fibre optique.

Du fait notamment de la présence de la fibre optique, ce second type d'organe de mesure de tension s'avère relativement complexe d'un point de vue câblage. En particulier, ce second type d'organe nécessite de modifier la structure du véhicule pour y faire passer la fibre optique.

Un deuxième objectif de l'invention, pris seul ou en combinaison avec le premier objectif, est de proposer un organe de mesure de tension qui s'affranchisse des problèmes rencontrés avec les organes de l'état de la technique.

Enfin, un troisième objectif de l'invention est de proposer un organe de mesure de l'énergie consommée par une chaîne de traction ferroviaire. DE 10 2004 042 101 A1 propose un dispositif d'isolement de moyens d'alimentation d'un système de mesure connecté à un potentiel haute tension.

Afin de répondre au premier objectif, l'invention propose selon un premier aspect un isolateur de toiture comme définie par la revendication 1.

Certains aspects préférés, mais non limitatifs, de ce dispositif sont les suivants :
- l'organe de mesure de courant présentant une structure articulée supportée par un châssis, le tronçon est une portion de ladite structure articulée ;
- le tronçon est une portion du châssis, ou un tronçon de matériau inséré dans le châssis ;
- les moyens de détermination sont associés à des moyens de calcul du courant consommé à partir de la différence de potentiel déterminée et d'une caractérisation de la résistivité du tronçon ;
- les moyens de détermination sont associés à des moyens de détection du potentiel à chacune des extrémités du tronçon ;
- les moyens de détermination comprennent un amplificateur opérationnel configuré pour comparer le potentiel détecté à chacune des extrémités du tronçon et pour déterminer le courant consommé à partir de la différence de potentiel déterminée et d'une caractérisation de la résistivité du tronçon ;
- le dispositif comporte en outre une sonde de température agencée sur l'organe de captage de courant, ladite sonde étant relié à l'amplificateur opérationnel pour en faire varier le gain en fonction de la température ;
- le dispositif comporte en outre des moyens d'alimentation ayant pour potentiel de référence le potentiel de l'organe de captage de courant ;
- les moyens d'alimentation sont alimentés par la batterie du véhicule par l'intermédiaire d'un transformateur d'isolement ;
- le transformateur d'isolement est intégré dans un pied de l'organe de captage de courant ;
- le dispositif est intégré dans un boîtier fixé à un châssis de support de l'organe de captage de courant ;
- le dispositif est logé dans le pied dans lequel le transformateur d'isolement est intégré ;
- les résultats de la mesure de courant sont véhiculés par une ligne de transmission passant par un pied de l'organe de captage de courant ;
- le dispositif comporte en outre un transformateur de courant intégré sur un châssis de support de l'organe de captage de courant ;
- le dispositif est en outre adapté pour fournir une mesure de la tension délivrée par la ligne caténaire et comporte à cet effet un diviseur de tension résistif ayant pour potentiel de référence le potentiel de l'organe de captage de courant ;
- le diviseur de tension résistif est relié à la masse par l'intermédiaire-d'un pied de l'organe de captage de courant ;
- le dispositif comporte en outre un multiplicateur pour calculer l'énergie consommée par la chaîne de traction en multipliant la mesure de courant et la mesure de tension ;

D'autres aspects, buts et avantages de la présente invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est un schéma d'un pantographe dont un tronçon du bras inférieur est utilisé conformément à l'invention pour déterminer une différence de potentiel proportionnelle au courant circulant dans le pantographe ;
- la figure 2 représente un mode de réalisation possible du dispositif selon l'invention ;
- la figure 3 est un schéma d'un pantographe dont un tronçon du châssis support est utilisé conformément à l'invention pour déterminer une différence de potentiel proportionnelle au courant circulant dans le pantographe.

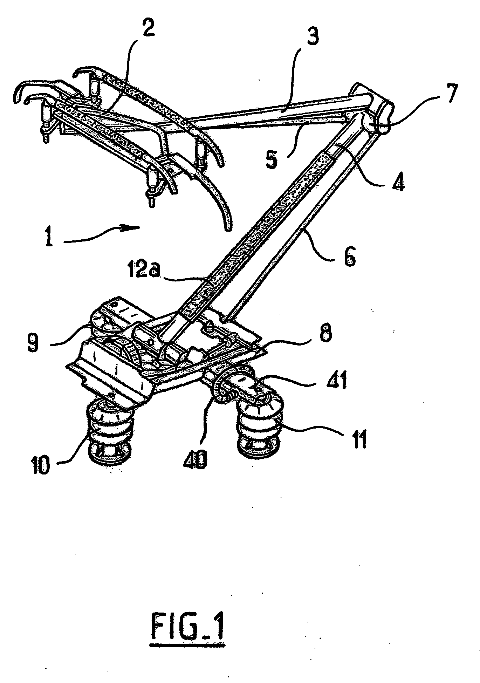

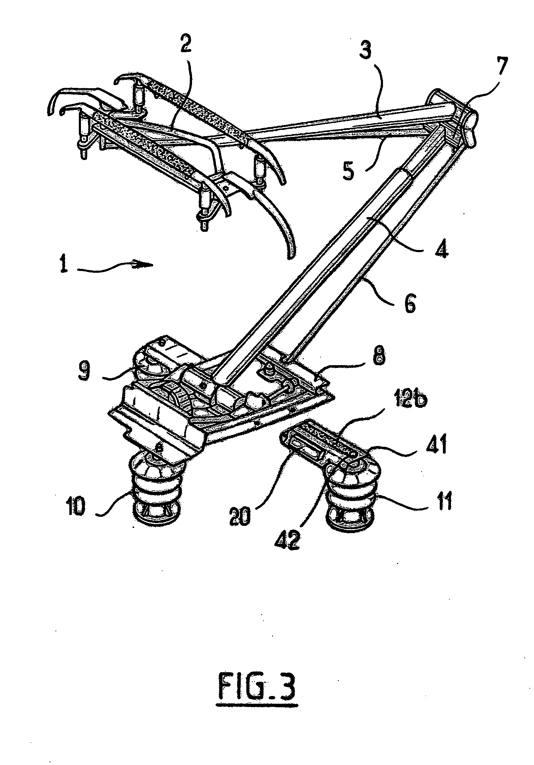

On a représenté sur les figures 1 et 3 un organe de captage de courant 1 de type pantographe sur lequel circule le courant capté depuis une ligne caténaire, à destination de la chaîne de traction dudit véhicule.

Le pantographe 1 est typiquement une structure articulée doté d'un archet 2 destiné à être en contact avec la ligne caténaire, et de deux bras, respectivement supérieur 3 et inférieur 4, reliés entre eux par l'intermédiaire d'une articulation 7, et chacun associé à une bielle 5, 6.

Le bras inférieur 4 est monté sur un châssis de support 8 du pantographe disposé sur le toit du véhicule ferroviaire. Le châssis est constitué d'un cadre reposant sur des pieds 9, 10, 11 qui permettent notamment d'isoler le pantographe de la toiture.

Le pied 11 notamment est relié au cadre du châssis 8 par l'intermédiaire d'un bras portant la référence 41 sur les figures 1 et 3.

On relèvera dès à présent, comme cela est illustré sur la figure 3, que l'invention prévoit selon un mode de réalisation possible d'avoir le bras 41 réalisé de manière détachable vis-à-vis du cadre du châssis 8.

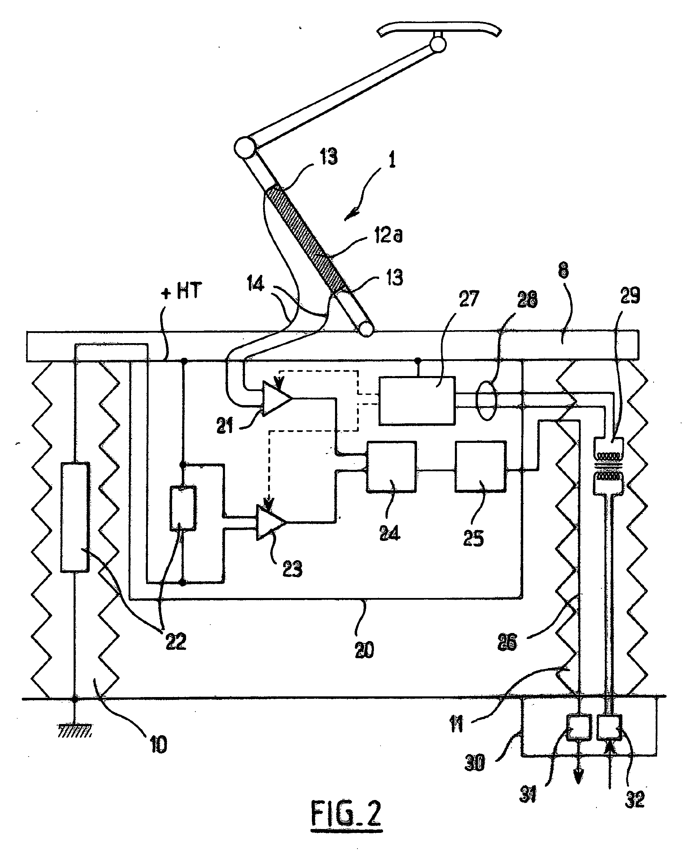

La figure 2 est un exemple d'un mode de réalisation possible du dispositif 20 selon l'invention pour la mesure du courant consommé par une chaîne de traction d'un véhicule ferroviaire.

Le dispositif 20 selon l'invention comporte des moyens de détermination d'une différence de potentiel proportionnelle au courant circulant sur un tronçon du pantographe 1.

Le courant capté par le pantographe sur la ligne caténaire circule effectivement dans la structure du pantographe, et passe ainsi par les deux bras 3, 4 puis par le châssis 8 et des points de connexion avec la ligne de puissance acheminant le courant capté par le pantographe à destination du moteur électrique.

De manière préférentielle, et comme cela est représenté sur la figure 2, le tronçon 12a utilisé dans le cadre de l'invention pour la détermination d'une différence de potentiel correspond à tout ou partie du bras inférieur 4. Un tel tronçon est ainsi arrangé le long de la structure du pantographe 1 en dessous de l'articulation 7, et à proximité du châssis de support 8, et par conséquent, comme cela sera apparent par la suite, à proximité du dispositif de mesure.

On notera qu'il s'avère alors préférable d'isoler électriquement la bielle 6 associé au bras inférieur 4, de sorte que tout le courant capté par l'archet 2 passe effectivement par le tronçon 12a du bras inférieur 6.

L'invention n'est toutefois pas limitée à un tronçon sur le bras inférieur, et on pourrait également utiliser un tronçon du bras supérieur 3, ou encore un tronçon correspondant à tout ou partie des deux bras.

Par ailleurs, et comme cela est représenté sur la figure 3, ledit tronçon utilisé dans le cadre de l'invention pour la détermination d'une différence de potentiel n'est pas limitée à un tronçon de la structure articulée du pantographe 1, mais peut également être constitué par une portion 12b du châssis 8.

Il s'agit par exemple d'un tronçon de l'un des bras 41 du châssis, ou encore comme cela est représenté sur la figure 3, d'un tronçon 12b de matériau à la résistivité calibrée que l'on vient insérer dans la structure de l'un des bras 41 du châssis. De manière avantageuse, le bras 41 est détachable du châssis 8.

Le pantographe 1 est formé en un matériau (typiquement en acier) de composition connue. Les bras du pantographe ont en outre une forme (typiquement tubulaire) connue.

Le matériau, la section et la longueur du tronçon 12a considéré étant connus, Il s'avère possible d'en caractériser la résistance ohmique. A titre d'exemple, la résistivité d'un bras d'un pantographe fabriqué par la société Faiveley Transport est d'environ 200µΩ/m.

De manière similaire, la résistivité d'une portion du châssis 8 peut également être calibrée.

Et bien entendu, dans le mode de réalisation selon lequel on vient insérer un tronçon 12b de matériau dans la structure de l'un des bras du châssis, on choisit un matériau dont la résistivité est parfaitement calibrée.

Les moyens de détermination de la différence de potentiel proportionnelle au courant circulant sur le tronçon 12a, 12b sont associés à des moyens de détection du potentiel à chacune des extrémités du tronçon.

Dans le cadre du mode de réalisation représenté sur les figures 1 et 2, ces moyens de détection du potentiel à une extrémité du tronçon 12a prennent par exemple la forme d'un collier 13 positionné sur le pantographe en entourant une extrémité du tronçon 12a de manière à palper le potentiel à cette extrémité. Les colliers 13 peuvent par exemple être vissés ou encore collés au pantographe.

Dans le cadre du mode de réalisation de la figure 3, on relèvera que le tronçon 12b inséré dans le bras 41 peut être relié, du côté du pied 11, au point de départ 42 de la ligne haute tension.

Un câble 14 est associé à chacun des moyens de détection du potentiel pour amener l'information de potentiel détecté en entrée de moyens de calcul 21 du courant consommé.

Les moyens de calcul 21 prennent par exemple la forme d'un amplificateur opérationnel configuré pour comparer le potentiel détecté à chacune des extrémités du tronçon 12a, 12b et pour déterminer le courant consommé sur la base ladite comparaison de potentiels et de la résistivité du tronçon.

On relèvera que la résistivité considérée peut être fixe, ou encore variable, notamment pour tenir compte des conditions ambiantes.

Le gain de l'amplificateur 21 peut ainsi être modifié pour tenir compte des variations de résistivité.

Il s'agit par exemple de tenir compte de la variation de la résistivité du tronçon en fonction de la température. A cet égard, une sonde de température (non représentée), par exemple un thermocouple, peut être rapportée sur le pantographe et reliée aux moyens de calcul du courant consommé pour faire varier le gain de l'amplificateur 21.

La résistance ohmique du pantographe peut effectivement s'étendre sur une plage allant de 200µΩ/m (à -15°C) à 240µΩ/m (à 100°C), et on comprend que la variation du gain de l'amplificateur 21 en fonction de la température détectée par la sonde permet de tenir compte des conditions de température extérieure et de l'échauffement du bras en fonction du courant de traction circulant dans le pantographe.

L'amplificateur 21 peut être relié à un convertisseur analogique/numérique 24 fournissant en sortie la valeur du courant consommé sous forme numérique.

Le convertisseur 24 peut quant à lui être relié à un multiplexeur 25 dont la fonction sera explicitée plus en détail par la suite.

Le dispositif 20 selon l'invention comporte en outre des moyens d'alimentation 27. Sur la figure 2, une ligne pointillée représente ainsi l'alimentation de l'amplificateur 21 par ces moyens d'alimentation 27.

Dans la mesure où la différence de potentiel déterminée est référencée par rapport au potentiel de la caténaire, le dispositif de mesure 20 selon l'invention doit également être référencé au potentiel du pantographe, c'est-à-dire au potentiel haute tension indiqué par +HT sur la figure 2.

Comme illustré sur la figure 2, les moyens d'alimentation 27 ont ainsi pour potentiel de référence le potentiel +HT du pantographe.

Ces moyens d'alimentation 27 sont reliés à la batterie du véhicule ferroviaire, laquelle a pour potentiel de référence, celui de la masse. Un transformateur d'isolement 29 est alors prévu, qui est relié d'une part à la batterie du véhicule via une interface d'alimentation 32 logée dans un boîtier d'interface 30, et d'autre part aux moyens d'alimentation 27 du dispositif 20 via un câble d'alimentation 20.

De manière préférentielle, le transformateur d'isolement 29 est intégré dans un pied 11 de support du pantographe 1.

Les résultats de la mesure de courant sont quant à eux véhiculés par une ligne de transmission 26 passant par le pied 11 dans le mode de réalisation représenté sur la figure 2, à destination d'une interface de mesure 31 logé dans le boîtier d'interface 30.

La ligne de transmission 26 est par exemple une fibre optique.

En variante, les résultats de la mesure peuvent être transmis à l'interface de mesure 31 par une liaison radio, une liaison infra-rouge ou encore en utilisant le transformateur d'isolement 29 lui-même.

On souligne ici que le boîtier d'interface 30 a notamment pour fonction d'assurer l'interface entre le dispositif de mesure 20 et la chaîne de traction ferroviaire. La mesure de courant est alors classiquement utilisée notamment pour assurer une protection de la chaîne de traction.

La mesure de courant ainsi réalisée peut notamment permettre d'identifier le type d'alimentation délivrée par la ligne caténaire.

Le courant est effectivement d'environ 3 kA dans le cas d'une alimentation continue (gamme de tension 0-3kV), et d'environ 600 A dans le cas d'une alimentation alternative (gamme de tension 0-25kV).

Le gain de l'amplificateur 21 peut alors être modifié en fonction de la mesure de courant réalisée, de manière à tenir compte de la gamme de tension délivrée par la ligne caténaire. En particulier, le gain peut être augmenté dans le cas d'une alimentation alternative.

Selon un premier mode de réalisation, le dispositif 20 est intégré dans un boîtier électronique fixé, comme cela est schématiquement représenté sur les figures 2 et 3, au châssis 8 de support du pantographe.

Dans le mode de réalisation de la figure 3, le dispositif 20 est plus précisément fixé sur le bras détachable 41, de sorte que l'ensemble constitué du bras 41 et du pied 11 forme un ensemble détachable portant l'ensemble des organes nécessaires à la mesure.

Selon un autre mode de réalisation possible, le dispositif 20 est logé dans le pied 11 dans lequel est intégré le transformateur d'isolement 29.

Ici aussi, on peut prévoir que le pied 11 soit relié au cadre du châssis par l'intermédiaire d'un bras détachable.

On comprend que le dispositif selon l'invention présente, par comparaison avec les dispositifs de mesure de courant de l'état de la technique, un câblage simplifié entre les différents organes haute tension en toiture du véhicule ferroviaire. L'invention permet alors d'engendrer des réductions d'encombrement, de masse et de coût.

On comprend en particulier que dans la mesure où la transmission des résultats de la mesure est réalisée par l'intermédiaire d'une ligne de transmission 26 passant à l'intérieur de l'un des pieds isolateurs 11 du pantographe, la réalisation du câblage ne nécessite pas de modifier la structure du véhicule. En d'autres termes, la mise en oeuvre de la transmission des résultats de la mesure est « invisible » pour le constructeur du véhicule.

De manière avantageuse, le dispositif 20 peut également être utilisé pour réaliser une détection des harmoniques du courant réinjecté sur la ligne caténaire par la chaîne de traction. A cet effet, un module de décomposition en série de Fourier peut être agencé en sortie de l'amplificateur 21 pour identifier les différentes harmoniques du courant réinjecté. Ces harmoniques sont alors comparées avec différents gabarits, de manière à vérifier la compatibilité de la pollution harmonique avec différentes contraintes réglementaires.

Le dispositif selon l'invention peut en outre être adapté pour fournir une mesure de la tension délivrée par la ligne caténaire.

Dans ce cas, le dispositif 20 comprend un diviseur de tension, typiquement un diviseur de tension résistif 22, ayant pour potentiel de référence le potentiel +HT de l'organe de captage de courant 1, et relié à la terre via un pied isolateur 10 de l'organe de captage de courant.

De manière particulièrement avantageuse, le diviseur de tension pourrait être relié à la terre via le pied 11, c'est-à-dire via le même pied que celui dans lequel le transformateur 29 est intégré.

Le diviseur de tension 22 est associé à un amplificateur 23 dont la sortie est reliée au convertisseur analogique/numérique 24, et qui est alimenté par les moyens d'alimentation 27 de la même manière que l'est l'amplificateur 21 de mesure du courant.

Un multiplicateur (non représenté) peut être intégré au dispositif 20 pour multiplier entre elles la mesure de courant et la mesure de tension. Une mesure de puissance ou d'énergie consommée par la chaîne de traction est ainsi obtenue.

Le multiplexeur 25 peut alors être utilisé pour transmettre sur un même canal (par exemple la ligne de transmission 26 de type fibre optique) les résultats de la mesure de courant, de la mesure de tension, et de la mesure d'énergie.

La mesure de tension peut en outre être utilisée pour commuter les gains de l'un et/ou l'autre des amplificateurs 21, 23 en fonction de la gamme de tension. A titre d'exemple le gain de l'amplificateur 21 de mesure de courant peut être augmenté lorsque la tension mesurée est dans la gamme 15kV-25kV représentative d'une alimentation en courant alternatif, et réciproquement diminué lorsque la tension mesurée est dans la gamme 1,5kV-3kV représentative d'une alimentation en courant continu.

On mentionne ici que la mesure de tension présentée ci-dessus mise en oeuvre à l'aide d'un diviseur de tension ayant pour potentiel de référence le potentiel +HT du pantographe, et de l'amplificateur 23 alimenté par les moyens d'alimentation 27 également au potentiel du pantographe peut être mise en oeuvre isolément de la mesure de courant présenté ci-dessus.

Cette mesure de tension peut également être associée à d'autres types de dispositif de mesure de courant, notamment les dispositifs de mesure de courant connus de l'état de la technique, pour fournir une mesure de l'énergie consommée par une chaîne de traction ferroviaire.

Selon un mode de réalisation particulier, le dispositif de mesure de courant 20 selon le premier aspect de l'invention peut être associé à un autre type d'organe de mesure de courant, à savoir un transformateur de courant 40 intégré sur le châssis 8 du pantographe 1 comme cela est représenté sur la figure 1. Le transformateur de courant est par exemple réalisé sous la forme d'une spire enroulée autour d'un bras 41 reliant le cadre du châssis 8 à l'un des pieds 11.

Le transformateur de courant 40 permet de réaliser une mesure précise du courant consommé par la chaîne de traction, notamment dans le cas d'une alimentation en courant alternatif.

On retiendra que le transformateur de courant 40 peut également être prévu de manière isolée, sans être associé au dispositif de mesure par détermination d'une différence de potentiel proportionnelle au courant circulant sur un tronçon du pantographe, pour fournir une mesure du courant consommé par la chaîne de traction. Dans une telle configuration, le transformateur de courant 40 peut être associé ou non à un dispositif de mesure de tension du type de celui précédemment décrit.

## Revendications

1. Isolateur (11) de toiture d'un véhicule ferroviaire équipé d'un organe de captage de courant (1) sur lequel circule le courant capté depuis une ligne caténaire, le courant étant consommé par une chaîne de traction du véhicule ferroviaire, l'isolateur dans lequel sont logés:
- un transformateur d'isolement (29) apte à être relié d'une part à une batterie du véhicule ferroviaire et d'autre part à des moyens d'alimentation d'un organe de mesure du courant consommé par la chaîne de traction ;
- un organe de mesure de la tension (22) délivrée par la ligne caténaire ;
- un multiplicateur pour calculer l'énergie consommée par la chaîne de traction en multipliant la mesure de tension délivrée par l'organe de mesure de la tension et une mesure de courant délivrée par l'organe de mesure du courant.

2. Isolateur selon la revendication 1, dans lequel passe une ligne de transmission (26) pour véhiculer les résultats de la mesure de courant.

3. Isolateur selon la revendication 2, dans lequel la ligne de transmission est une fibre optique.

4. Isolateur selon l'une des revendications 1 à 3, dans lequel l'organe de mesure de la tension est un diviseur de tension résistif (22) ayant pour potentiel de référence le potentiel (+HT) de l'organe de captage de courant et relié à la masse par l'intermédiaire de l'isolateur.

5. Isolateur selon l'une des revendications précédentes, dans lequel l'isolateur est un pied isolateur (11) d'un châssis de support de l'organe de captage de courant.

6. Isolateur selon l'une des revendications précédentes, dans lequel est également logé l'organe de mesure du courant consommé par la chaîne de traction.

7. Isolateur selon l'une des revendications précédentes, dans lequel le transformateur d'isolement est également apte à relier la batterie du véhicule ferroviaire et à des moyens d'alimentation de l'organe de mesure de la tension délivrée par la ligne caténaire.

8. Système comprenant un isolateur selon l'une des revendications 1 à 5 et un organe de mesure du courant consommé par la chaîne de traction du véhicule ferroviaire.

9. Système selon la revendication 8, dans lequel l'organe de mesure du courant est un transformateur de courant (40) apte à réaliser une mesure du courant alternatif consommé par la chaîne de traction du véhicule ferroviaire.

10. Système selon la revendication 9, dans lequel le transformateur de courant est intégré sur un châssis de support (8) de l'organe de captage de courant.

11. Système selon la revendication 8, dans lequel l'organe de mesure du courant est un shunt apte réaliser une mesure du courant continu consommé par la chaîne de traction.

12. Système selon la revendication 8, dans lequel l'organe de mesure du courant comporte un transformateur de courant (40) apte à réaliser une mesure du courant alternatif consommé par la chaîne de traction et un shunt apte réaliser une mesure du courant continu consommé par la chaîne de traction.

## Claims

1. Isolator (11) on the roof of a railway vehicle equipped with a current-collecting unit (1) on which the current collected from a catenary line flows, the current being consumed by a traction unit of the railway vehicle, the isolator in which there are housed:
- an isolating transformer (29) able to be connected firstly to a battery of the railway vehicle and secondly to means of supplying a unit measuring the current consumed by the traction unit;
- a unit (22) measuring the voltage delivered by the catenary line;
- a multiplier for calculating the energy consumed by the traction unit by multiplying the voltage measurement delivered by the voltage-measurement unit and a current measurement delivered by the current-measurement unit.

2. Isolator according to claim 1, through which a transmission line (26) passes for conveying the results of the current measurement.

3. Isolator according to claim 2, in which the transmission line is an optical fibre.

4. Isolator according to one of claims 1 to 3, in which the voltage-measurement unit is a resistive voltage divider (22) having as its reference potential the potential (+HT) of the current-collecting unit and connected to earth by means of the isolator.

5. Isolator according to one of the preceding claims, in which the isolator is an isolating foot (11) of a frame supporting the current-collecting unit.

6. Isolator according to one of the preceding claims, in which the unit measuring the current consumed by the traction unit is also housed.

7. Isolator according to one of the preceding claims, in which the isolating transformer is also able to connect the battery of the railway vehicle and to means of supplying the unit measuring the voltage delivered by the catenary line.

8. System comprising an isolator according to one of claims 1 to 5 and a unit for measuring the current consumed by the traction unit of the railway vehicle.

9. System according to claim 8, in which the current-measurement unit is a current transformer (40) able to perform a measurement of the alternating current consumed by the traction unit of the railway vehicle.

10. System according to claim 9, in which the current transformer is integrated on a frame (8) supporting the current-collecting unit.

11. System according to claim 8, in which the current-measurement unit is a shunt able to perform a measurement of the direct current consumed by the traction unit.

12. System according to claim 8, in which the current-measurement unit comprises a current transformer (40) able to perform a measurement of the alternating current consumed by the traction unit and a shunt able to perform a measurement of the direct current consumed by the traction unit.

## Patentansprüche

1. Dachisolator (11) für ein Schienenfahrzeug mit einem Stromabnehmerorgan (1), in dem der aus einer Fahrleitung abgenommene Strom fließt, wobei der Strom von einer Antriebseinheit des Schienenfahrzeugs verbraucht wird, wobei in dem Isolator Folgendes angeordnet ist:
- ein Isolationstransformator (29), der dazu geeignet ist, einerseits mit einer Batterie des Schienenfahrzeugs und andererseits mit Mitteln zur Versorgung eines Organs zur Messung des Stroms, der von der Antriebseinheit verbraucht wird, verbunden zu werden;
- ein Organ zur Messung der Spannung (22), die von der Fahrleitung bereitgestellt wird;
- einen Multiplikator, um die von der Antriebseinheit verbrauchte Energie zu berechnen, indem er den Spannungsmesswert, der von dem Organ zur Spannungsmessung bereitgestellt wird, mit einem Strommesswert, der von dem Organ zur Strommessung bereitgestellt wird, multipliziert.

2. Isolator nach Anspruch 1, in dem eine Übertragungsleitung (26) verläuft, um die Ergebnisse der Strommessung zu transportieren.

3. Isolator nach Anspruch 2, wobei die Übertragungsleitung ein Lichtleiter ist.

4. Isolator nach einem der Ansprüche 1 bis 3, wobei das Organ zur Spannungsmessung ein ohmscher Spannungsteiler (22) ist, dessen Referenzpotential das Potential (+HS) des Stromabnehmerorgans ist und der mittels des Isolators mit der Masse verbunden ist.

5. Isolator nach einem der vorhergehenden Ansprüche, wobei der Isolator ein Isolatorfuß (11) eines Trägerrahmens des Stromabnehmerorgans ist.

6. Isolator nach einem der vorhergehenden Ansprüche, in dem auch das Organ zur Messung des Stroms, der von der Antriebseinheit verbraucht wird, angeordnet ist.

7. Isolator nach einem der vorhergehenden Ansprüche, wobei der Isolationstransformator auch dazu geeignet ist, mit der Batterie des Schienenfahrzeugs und mit Mitteln zur Versorgung des Organs zur Messung der Spannung, die von der Fahrleitung bereitgestellt, verbunden zu werden.

8. System, umfassend einen Isolator nach einem der Ansprüche 1 bis 5, und ein Organ zur Messung des Stroms, der von der Antriebseinheit des Schienenfahrzeugs verbraucht wird.

9. System nach Anspruch 8, wobei das Organ zur Strommessung ein Stromwandler (40) ist, der dazu geeignet ist, eine Messung des Wechselstroms durchzuführen, der von der Antriebseinheit des Schienenfahrzeugs verbraucht wird.

10. System nach Anspruch 9, wobei der Stromwandler an einem Trägerrahmen (8) des Stromabnehmerorgans integriert ist.

11. System nach Anspruch 8, wobei das Organ zur Strommessung ein Nebenschluss ist, der dazu geeignet ist, eine Messung des Gleichstroms durchzuführen, der von der Antriebseinheit verbraucht wird.

12. System nach Anspruch 8, wobei das Organ zur Strommessung einen Stromwandler (40) aufweist, der dazu geeignet ist, eine Messung des Wechselstroms durchzuführen, der von der Antriebseinheit des Schienenfahrzeugs verbraucht wird, und einen Nebenschluss, der dazu geeignet ist, eine Messung des Gleichstroms durchzuführen, der von der Antriebseinheit verbraucht wird.
